# EUROPEAN PATENT APPLICATION

(11) **EP 4 729 275 A1**
(43) Date of publication of application: **22.04.2026**
(21) Application number: 24841945.9
(22) Date of filing: 08.03.2024
(51) Int. Cl.: B29C 64/386, B33Y 50/00

(54) **3D PRINTING METHOD, TERMINAL DEVICE, READABLE STORAGE MEDIUM AND COMPUTER PROGRAM PRODUCT**

(30) Priority: 19.07.2023 CN 202310891002
(71) Applicant: Shanghai Lunkuo Technology Co., Ltd., Shanghai 200120 (CN)
(72) Inventor: WEI, Lianghui, Shanghai 200120 (CN); CHEN, Gushun, Shanghai 200120 (CN)
(74) Representative: Grünecker Patent- und Rechtsanwälte PartG mbB
(86) International application number: PCT/CN2024/080761
(87) International publication number: WO 2025/015942

(57) **Abstract**

The present application provides a 3D printing method, a terminal device, a readable storage medium, and a computer program product. The method includes: displaying all objects included in a three-dimensional model, where all the objects included in the three-dimensional model include a first object and a second object; displaying the first object and the second object in a differentiated manner in response to a user selecting the first object from all the objects included in the three-dimensional model; controlling the first object to be skipped from printing and controlling the second object to be printed; or controlling the first object to be printed and controlling the second object to be skipped from printing. In the implementation of the present application, some objects in the three-dimensional model can be printed during the 3D printing process, thereby providing good flexibility and wide applicability.

## Description

The present application claims priority to the Chinese Patent Application filed with the China National Intellectual Property Administration on July 19, 2023, with application number 202310891002.3 and titled "3D PRINTING METHOD, TERMINAL DEVICE, READABLE STORAGE MEDIUM, AND COMPUTER PROGRAM PRODUCT", the entire contents of which are incorporated herein by reference.

### TECHNICAL FIELD

The present application relates to the technical field of 3D printing, and in particular, to a 3D printing method, a terminal device, a readable storage medium, and a computer program product.

### BACKGROUND

3D printing technology is a technology for constructing objects by layer-by-layer printing through a 3D printer using bondable materials such as powdered metal or plastic based on digital model (3D design files) files. During the 3D printing process, a print batch includes a plurality of objects, and how to manage the plurality of objects is a key research problem.

### SUMMARY

The present application provides a 3D printing method, a terminal device, a readable storage medium, and a computer program product, which enable some objects in a three-dimensional model to be printed during the 3D printing process, thereby providing good flexibility and wide applicability.

In a first aspect, embodiments of the present application disclose a 3D printing method. The 3D printing method is specifically implemented as:
displaying all objects included in a three-dimensional model, where all the objects included in the three-dimensional model include a first object and a second object;
displaying the first object and the second object in a differentiated manner in response to a user selecting the first object from all the objects included in the three-dimensional model;
controlling the first object to be skipped from printing and controlling the second object to be printed; or controlling the first object to be printed and controlling the second object to be skipped from printing.

In the embodiments of the present application, all the objects included in the three-dimensional model are displayed, so as to help the user know the objects included in the three-dimensional model that need to be printed, and improve the user's information perception of the three-dimensional model. The user may make personalized selections of all the objects included in the three-dimensional model, and the selected objects and the unselected objects are displayed in a differentiated manner based on the user's selection. In one aspect, through the visual display effect, different types of objects are displayed in a differentiated manner intuitively and quickly, so as to help the user perceive the selection result. In another aspect, different print operations may be performed based on the user's selection, including printing some objects and skipping the printing of other objects. This not only enables personalized 3D printing but also improves the accuracy and flexibility of 3D printing, making it adaptable to printing scenarios with different needs.

With reference to the first aspect, in a first possible implementation, displaying all the objects included in the three-dimensional model includes:
displaying all the objects included in the three-dimensional model when detecting a user input on an object-skipping control.

In the implementation of the embodiments of the present application, an entry point is provided for the user. When the user needs to customize personalized 3D printing, all the objects included in the three-dimensional model may be displayed through the object-skipping control, such that the user can select all the objects of the three-dimensional model as required, thereby enabling personalized 3D printing.

With reference to the first aspect or the first possible implementation of the first aspect, in a second possible implementation, all the objects included in the three-dimensional model are displayed in a first zone; after the first object and the second object are displayed in the differentiated manner, the above 3D printing method further includes:
enlarging and displaying all objects in a target zone in a second zone in response to the user selecting the target zone in the first zone.

In the implementation of the embodiments of the present application, all the objects of the three-dimensional model may be displayed in the first zone, thereby allowing the user to select objects of the three-dimensional model in the first zone by means of range selection, which enriches the interaction methods. Meanwhile, all the objects in the target zone are enlarged and displayed in the second zone based on the user's selection, thereby reducing visual interference, allowing the user to perceive the selected objects more intuitively and quickly, and facilitating further printing decisions by the user.

With reference to the second possible implementation, in a third possible implementation, the method further includes:
switching, in response to an object selection operation of the user in the second zone, a selected first object in the target zone to an unselected state, and/or an unselected second object in the target zone to a selected state.

In the implementation of the embodiments of the present application, some objects are enlarged and displayed in the second zone, thereby effectively reducing visual interference and allowing the user to perform a toggling operation on a small number of objects, such as switching the selected state to the unselected state, and switching the unselected state to the selected state. The user thus achieves high selection accuracy for the enlarged objects in the second zone. Meanwhile, by performing a secondary selection of the objects in the second zone, the tolerance and flexibility of object selection are improved, which is beneficial for improving the accuracy of 3D printing.

With reference to the first aspect or the first possible implementation of the first aspect, in a fourth possible implementation, all the objects included in the three-dimensional model are displayed in a first zone;
displaying the first object and the second object in the differentiated manner in response to the user selecting the first object from all the objects included in the three-dimensional model includes:
enlarging and displaying all objects in a target zone in a second zone in response to the user selecting the target zone in the first zone; and
displaying the first object and the second object in the differentiated manner in response to the user selecting the first object from all the objects included in the target zone.

In the implementation of the embodiments of the present application, all the objects of the three-dimensional model are displayed in the first zone, the user may select a corresponding target zone in the first zone by means of range selection, and the terminal device may enlarge and display all the objects in the target zone in the second zone, thereby reducing visual interference and allowing the user to perceive the selected objects more intuitively and quickly. Further, the user may select the objects displayed in the first zone and the objects enlarged and displayed in the second zone as required, and the first object and the second object are displayed in a differentiated manner based on the user's selection. Through the visualized display effect, different types of objects are displayed in a differentiated manner intuitively and quickly, so as to help the user perceive the selection result.

With reference to the first aspect or the first possible implementation of the first aspect, in a fifth possible implementation, all the objects included in the three-dimensional model are displayed in a first zone; after the first object and the second object are displayed in the differentiated manner, the method further includes:
enlarging and displaying at least one of the first object and the second object in response to the user performing a zoom-in operation on a partial zone of the first zone.

In the implementation of the embodiments of the present application, the partial zone of the first zone is directly enlarged and displayed, thereby reducing visual interference, allowing the user to perceive the selected objects or the unselected objects more intuitively and quickly, and facilitating further printing decisions by the user.

With reference to the fifth possible implementation, in a sixth possible implementation, after the first object in the first zone or the second object in the second zone is enlarged and displayed, the method further includes:
switching, in response to an object selection operation of the user in the partial zone, a selected first object in the partial zone to an unselected state, and/or an unselected second object in the partial zone to a selected state.

In the implementation of the embodiments of the present application, some objects are directly enlarged and displayed in the first zone, thereby effectively reducing visual interference and allowing the user to perform a toggling operation on a small number of objects, such as switching the selected state to the unselected state, and switching the unselected state to the selected state. The user thus achieves high selection accuracy for the enlarged objects. Meanwhile, by performing a secondary selection of the objects in the second zone, the tolerance and flexibility of object selection are improved, which is beneficial for improving the accuracy of 3D printing. With reference to the first aspect or the first possible implementation of the first aspect, in a seventh possible implementation, all the objects included in the three-dimensional model are displayed in a first zone;
displaying the first object and the second object in the differentiated manner in response to the user selecting the first object from all the objects included in the three-dimensional model includes:
enlarging and displaying all objects in a partial zone of the first zone in response to the user performing a zoom-in operation on the partial zone of the first zone; and
displaying the first object and the second object in the differentiated manner in response to the user selecting the first object from all the objects included in the partial zone of the first zone.

In the implementation of the embodiments of the present application, all the objects of the three-dimensional model are displayed in the first zone, and the user may perform a zoom-in operation such that the partial zone of the first zone is enlarged and displayed. The objects in the partial zone are enlarged and displayed, thereby reducing visual interference and allowing the user to perceive the selected objects more intuitively and quickly. Further, the user may select the objects enlarged and displayed in the partial zone as required, and the first object and the second object are displayed in a differentiated manner based on the user's selection. Through the visualized display effect, different types of objects are intuitively and quickly displayed in a differentiated manner, so as to help the user perceive the selection result.

With reference to the first aspect or with reference to any one of the first to the seventh possible implementations of the first aspect, in an eighth possible implementation, all the objects included in the three-dimensional model further include a third object; the method further includes:
displaying the third object in a manner differentiated from a display manner of the first object and the second object in response to the user selecting the third object from all the objects included in the three-dimensional model.

In the implementation of the embodiments of the present application, in the case that the first object and the second object have been displayed in a differentiated manner, when the three-dimensional model further includes the third object, the user may further select the third object, and the first object, the second object, and the third object are displayed in a differentiated manner based on the user's selection result. In this case, the first object may be understood as the objects previously selected by the user, and the third object may be understood as the objects currently selected by the user. Thus, the objects previously selected by the user and the objects currently selected by the user may be displayed in a differentiated manner. In one aspect, through the visual display effect, different types of objects are displayed in a differentiated manner intuitively and quickly, so as to help the user perceive the selection result. In another aspect, different print operations may be performed by the user based on the user's selection, including printing some objects and skipping the printing of other objects. This not only enables personalized 3D printing but also improves the accuracy and flexibility of 3D printing, making it adaptable to printing scenarios with different needs.

With reference to the first aspect or with reference to any one of the first to the seventh possible implementations of the first aspect, in a ninth possible implementation, any object included in the three-dimensional model includes a first part and a second part; controlling the first object to be printed includes:
displaying the first part and the second part in the first object in a differentiated manner in response to the user selecting the first part from the first object.

Controlling the first object to be printed as described above may be specifically implemented as: controlling the first part to be skipped from printing and controlling the second part to be printed; or controlling the first part to be printed and controlling the second part to be skipped from printing.

In the implementation of the embodiments of the present application, any object in the three-dimensional model includes different types of parts, and all parts in one object share the same printing parameters. During the 3D printing process, in addition to selecting corresponding objects, the user may also select parts from a finer granularity dimension, and the parts are displayed in a differentiated manner based on the user's selection. In one aspect, through the visual display effect, different types of parts are displayed in a differentiated manner intuitively and quickly, so as to help the user perceive the selection result. In another aspect, different print operations may be performed based on the user's selection of parts, including printing some parts in the same object and skipping the printing of other parts in the same object. This not only enables personalized 3D printing but also improves the accuracy and flexibility of 3D printing, making it adaptable to printing scenarios with different needs.

With reference to the first aspect or with reference to any one of the first to the ninth possible implementations of the first aspect, in a tenth possible implementation, displaying the first object and the second object in the differentiated manner includes:
displaying the first object in the three-dimensional model in a first color; and
displaying the second object in the three-dimensional model in a second color.

In the implementation of the embodiments of the present application, the first object and the second object are displayed in a differentiated manner by using different colors. Through the visual display effect, different types of objects are displayed in a differentiated manner intuitively and quickly, so as to help the user perceive the selection result.

In a second aspect, the embodiments of the present application further disclose a terminal device, where the terminal device includes a processor and a display, the display is configured to display objects included in a three-dimensional model, and the processor is configured to perform the 3D printing method with reference to the first aspect or with reference to any one of the above possible implementations of the first aspect.

In a third aspect, the embodiments of the present application further disclose a non-transitory computer-readable storage medium storing computer instructions and having computer program instructions stored thereon, where the computer program instructions, when run by a processor, cause the processor to perform the 3D printing method with reference to the first aspect or with reference to any one of the above possible implementations of the first aspect.

In a fourth aspect, the embodiments of the present application further disclose a computer program product, where the computer program product includes computer programs, and the computer programs, when run by a processor, cause the processor to perform the 3D printing method with reference to the first aspect or with reference to any one of the above possible implementations of the first aspect.

It should be understood that for implementation and beneficial effects of the above aspects of the present application, reference may be made to each other.

### BRIEF DESCRIPTION OF THE DRAWINGS

FIG. 1 is a schematic diagram of a scenario of a terminal device according to an embodiment of the present application;
FIG. 2 is a schematic diagram of yet another scenario of a terminal device according to an embodiment of the present application;
FIG. 3 is a flowchart illustrating steps of a 3D printing method according to an embodiment of the present application;
FIG. 4A is a schematic diagram of a graphical user interface of an object-skipping control according to an embodiment of the present application;
FIG. 4B is a schematic diagram of a graphical user interface of all objects included in a three-dimensional model according to an embodiment of the present application;
FIG. 5 is a schematic diagram of a graphical user interface in which a first object and a second object are displayed in a differentiated manner according to an embodiment of the present application;
FIGs. 6A to 6E are schematic diagrams of a graphical user interface of a first zone and a second zone according to an embodiment of the present application;
FIG. 7 is a schematic diagram of yet another graphical user interface of a first zone and a second zone according to an embodiment of the present application;
FIGs. 8A to 8B are schematic diagrams of a graphical user interface in which a partial zone of a first zone is enlarged according to an embodiment of the present application;
FIGs. 9A to 9B are schematic diagrams of yet another graphical user interface of a first zone and a second zone according to an embodiment of the present application;
FIG. 10 is a schematic diagram of yet another graphical user interface of a first zone and a second zone according to an embodiment of the present application; and
FIG. 11 is a schematic diagram of a graphical user interface in which a first object, a second object, and a third object are displayed in a differentiated manner according to an embodiment of the present application.

### DETAILED DESCRIPTION

Technical solutions in the embodiments of the present application will be clearly and fully described below with reference to the accompanying drawings in the embodiments of the present application.

For ease of understanding the present application, technical features that may be involved in the technical solutions according to the present application are first described.

In 3D printing, a 3D printer prints a three-dimensional model based on the result of slicing the three-dimensional model by slicing software.

The slicing software is software that generates a control code (for example, gcode) based on a three-dimensional model. The gcode code has an association relationship with each object in the three-dimensional model. The slicing software generally runs on a terminal device or a cloud server. The terminal device may include a 3D printer, a functional module (such as a display module) in the 3D printer, at least one of a desktop computer, a laptop, a tablet computer, a smart screen, and a mobile phone terminal that establishes a communication connection with the 3D printer.

Illustratively, the slicing software may provide a graphical user interface that allows a user to perform an operation on the graphical user interface, for example, import a file in a format such as STL, DAE, or OBJ into the slicing software. In the slicing software, the user may set the printing parameters of the three-dimensional model and perform plate arranging on the three-dimensional model. Plate arranging may be understood as placing the three-dimensional model at a designated position on the virtual print table in a specified orientation. A three-dimensional model may include a plurality of objects, and an object may include a plurality of parts. Plate arranging may involve arranging the plurality of objects included in the three-dimensional model, and subsequently, the 3D printer prints the objects according to the layout during the plate arranging.

In one embodiment, during the plate arranging, the plurality of objects are required to be distributed across plates. For example, when there are too many objects to be printed in a single run, they can be divided into a plurality of batches for printing. This process is referred to as batch printing. That is, the plurality of objects are distributed across a plurality of plates (also referred to as plates for batch printing) for printing, where three-dimensional models in the same batch belong to the same plate. The "plate" refers to a virtual plate, the dimension of which corresponds to that of a printing plate in the 3D printer, and the printing plate is placed on the hot bed of the printer.

The slicing software may perform slicing operations on all objects in at least one plate to generate slice data (for example, number of slices, height of slices per layer, and the like). Then, the slicing software generates a control code of the printing path of each layer of slices based on the slice data as a slicing result, and the slicing result is used for controlling the printing head of the 3D printer to move along the printing path.

Implementations of the technical solutions of the present application will be further described in detail below with reference to the accompanying drawings.

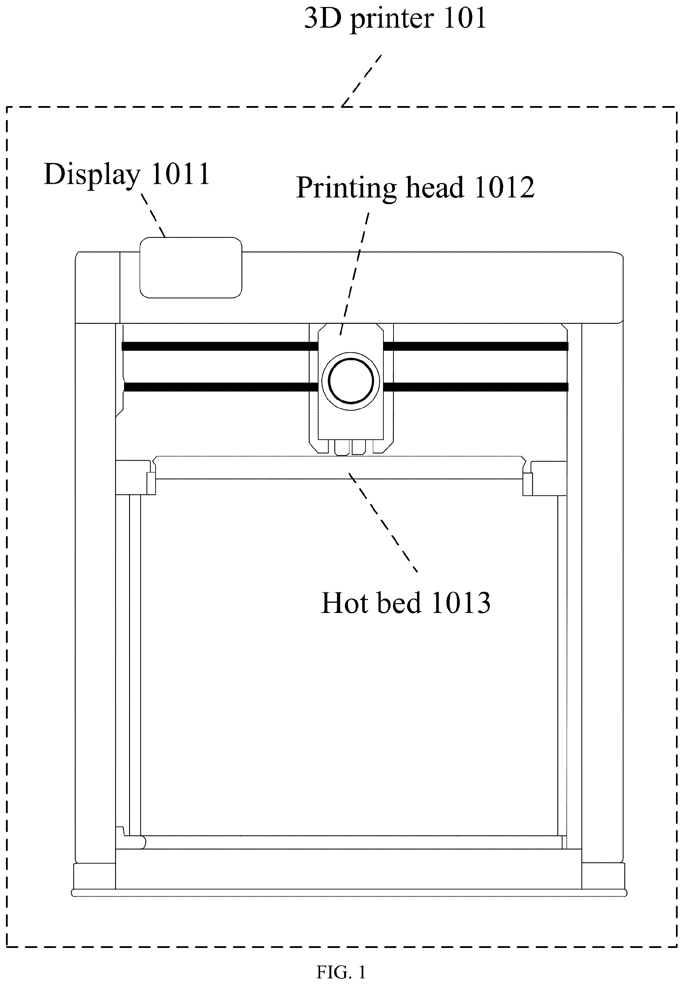

In some feasible implementations, referring to FIG. 1, FIG. 1 is a schematic diagram of a scenario of a terminal device according to an embodiment of the present application. As shown in FIG. 1, the terminal device according to the embodiment of the present application may be specifically implemented as a 3D printer 101 or a display module in the 3D printer.

The 3D printer 101 includes a display 1011. The display 1011 can display a graphical user interface of the 3D printer 101, for example, display a three-dimensional model, all objects included in the three-dimensional model, all parts included in the objects, and the like.

Illustratively, the 3D printer 101 further includes a printing head 1012 and a hot bed 1013. The printing head 1012 is configured to heat the printing material to a molten state. The hot bed 1013 is configured to carry an object printed by the 3D printer 101. Illustratively, a printing plate (not shown) may be arranged on a side of the hot bed 1013 proximal to the printing head 1012. In a specific implementation, the printing head 1012 can extrude the printing material in a molten state onto a printing plate while moving along the printing path of the 3D printer 101, thereby printing a three-dimensional object layer by layer.

The 3D printer 101 further includes a processor. The processor may be a micro control unit (MCU), a central processing unit (CPU), another general-purpose processor, a digital signal processor (DSP), an application specific integrated circuit (ASIC), a field-programmable gate array (FPGA), another programmable logic device, a discrete gate or a transistor logic device, a discrete hardware assembly, or the like. In one embodiment, the processor may be arranged at the printing head 1012 or at the display 1011. The display 1011 and the processor arranged at the display 1011 constitute a display module of the 3D printer 101.

In the embodiments of the present application, the 3D printer may display, via the display, all objects included in the three-dimensional model, and the user may also make personalized selections of all the objects included in the three-dimensional model in the display. The display displays the selected objects and the unselected objects in a differentiated manner based on the user's selection. In this case, the 3D printer may perform different print operations based on the user's selection, including printing some objects and skipping the printing of other objects, thereby providing good flexibility and high adaptability.

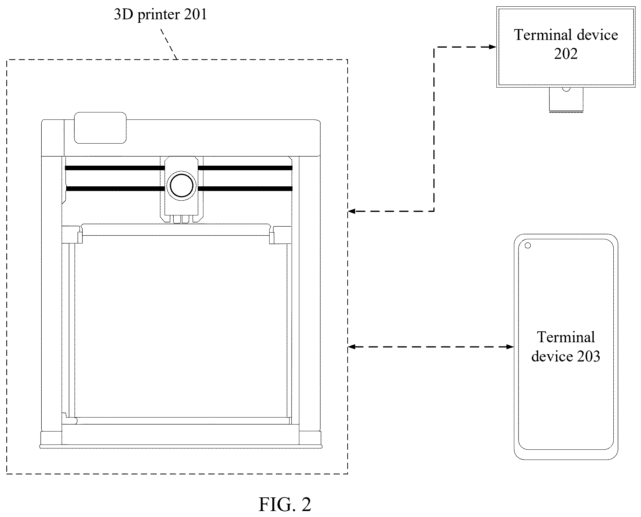

In one embodiment, in some feasible implementations, referring to FIG. 2, FIG. 2 is a schematic diagram of yet another scenario of a terminal device according to an embodiment of the present application. As shown in FIG. 2, the terminal device according to the embodiment of the present application may be specifically implemented as a desktop computer, a laptop, a tablet computer, a smart screen, a mobile phone terminal, and the like that establish a communication connection with the 3D printer.

The at least one terminal device (for example, a terminal device 202 or a terminal device 203) may have a communication connection with the 3D printer 201. In a specific implementation, the 3D printer 201 may establish a communication connection with at least one of the terminal device 202 and the terminal device 203 via a local area network, WIFI, Bluetooth, P2P, or the like. Alternatively, the 3D printer 201 may establish communication with at least one of the terminal device 202 and the terminal device 203 via a cloud server (not shown).

The terminal device 202 and the terminal device 203 include a display and a processor. The display may display, for example, a three-dimensional model, all objects included in the three-dimensional model, all parts included in the objects, and the like. The processor may be an MCU, a CPU, another general-purpose processor, a DSP, an ASIC, an FPGA, another programmable logic device, a discrete gate or a transistor logic device, a discrete hardware assembly, or the like.

In the embodiments of the present application, the terminal device 202 or the terminal device 203 may display all objects included in the three-dimensional model, and the user may select any object included in the three-dimensional model from a graphical user interface provided by the terminal device 202 or the terminal device 203. The terminal device 202 or the terminal device 203 displays the selected objects and the unselected objects in a differentiated manner based on the user's selection, and may transmit a print instruction to the 3D printer 201 to instruct the 3D printer 201 to perform corresponding print operations (such as skipping the printing of a first object and printing a second object), thereby providing good flexibility and high adaptability.

Specific implementations of the 3D printing method according to the present application will be described in detail below with reference to the accompanying drawings.

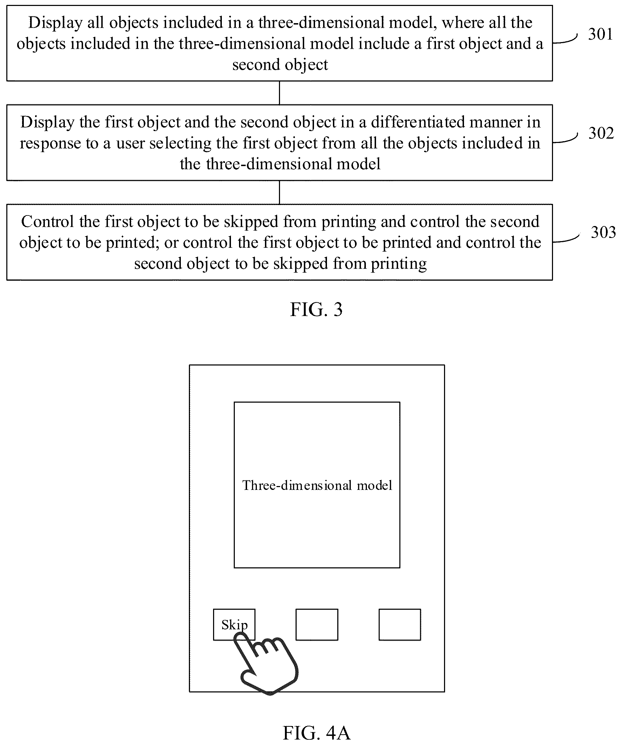

Referring to FIG. 3, FIG. 3 is a flowchart illustrating steps of a 3D printing method according to an embodiment of the present application. Specifically, the following steps may be included.

In step 301, all objects included in a three-dimensional model are displayed, where all the objects included in the three-dimensional model include a first object and a second object.

In some feasible implementations, the embodiments of the present application may be applied to a terminal device. The terminal device may include a 3D printer, a functional module (such as a display module) in the 3D printer, or a desktop computer, a laptop, a tablet computer, a smart screen, a mobile phone terminal, and the like that establish a communication connection with the 3D printer. Illustratively, the terminal device may also detect a user operation to control the 3D printing process based on the user operation.

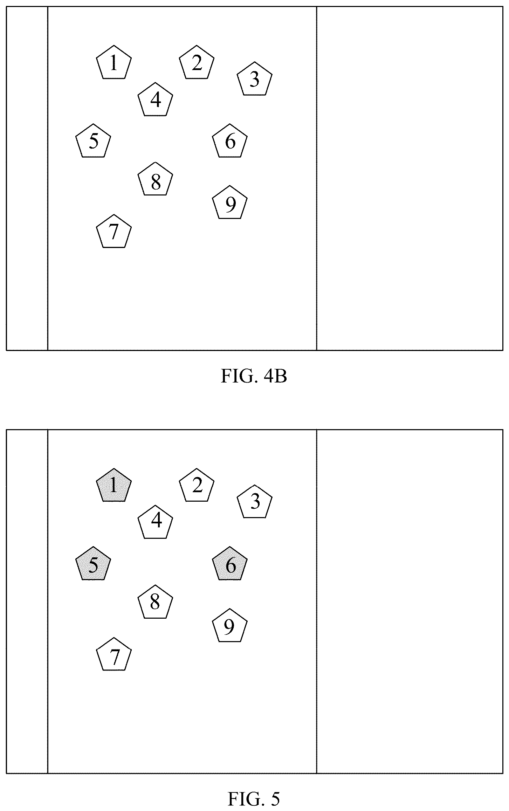

In some feasible implementations, the terminal device may display all objects included in the three-dimensional model when detecting a user input on an object-skipping control. Illustratively, as shown in FIG. 4A, the terminal device may provide a button for the object-skipping control in the graphical user interface. When the user taps the button for the object-skipping control, the terminal device displays as shown in FIG. 4B. That is, the terminal device displays all the objects included in the three-dimensional model, for example, object 1, object 2, object 3, object 4, object 5, object 6, object 7, object 8, and object 9 included in the three-dimensional model. In one embodiment, the terminal device provides a text box input of the object-skipping control in the graphical user interface, in which the user may input text, numbers, letters, or the like, such that the terminal device can also display as shown in FIG. 4B. That is, the specific implementation of the object-skipping control is not limited in the embodiments of the present application. In the implementation of the embodiments of the present application, an entry point is provided for the user. When the user needs to customize personalized 3D printing, the display of all the objects included in the three-dimensional model is triggered by the input on the object-skipping control, such that the user can select all the objects of the three-dimensional model as required to enable personalized 3D printing.

In one embodiment, in some feasible implementations, during the printing process of all objects of the 3D printer on the same plate, if the 3D printer detects that the printing of an object fails, for example, due to a failure in layer-to-layer adhesion of the object or insufficient printing material for the object, the terminal device is triggered to display as shown in FIG. 4B. That is, the terminal device displays all objects included in the three-dimensional model, such that the terminal device continues to execute step 302. It can be understood that during the 3D printing process, if the printing of any object or part in a certain print batch fails, all objects or parts in the print batch will be affected. For example, extrusion of a printing material on the object that fails to be printed causes nozzle stringing on the 3D printer, and the nozzle stringing affects the printing of the next object. Alternatively, the objects of the 3D printer in the same print batch are not necessarily all required to be printed by the user, and the user can only choose to print the three-dimensional model on the entire virtual plate and cannot enable personalized 3D printing. In the implementation of the embodiments of the present application, all the objects included in the three-dimensional model may be graphically displayed if the printing of an object fails, such that the user establishes a correspondence between the object that fails to be printed and an object among all objects displayed on the terminal device, so as to skip the printing of the object that fails to be printed. This can effectively advance the printing task and prevent the overall printing progress from being affected by the printing failure of individual objects or parts.

In step 302, the first object and the second object are displayed in a differentiated manner in response to the user selecting the first object from all the objects included in the three-dimensional model.

Illustratively, the user may select, from the three-dimensional model shown in FIG. 4B, the first object to include object 1, object 5, and object 6. In this case, the first object and the second object may be displayed in a differentiated manner as shown in FIG. 5. In this case, the first object, including object 1, object 5, and object 6, is displayed with gray fill, and the second object, including object 2, object 3, object 4, object 7, object 8, and object 9, is displayed without fill.

It should be noted that FIG. 5 shows an example in which the first object and the second object are distinguished through a differentiated color display. For example, the terminal device displays the first object in the three-dimensional model in a first color, and displays the second object in the three-dimensional model in a second color. In some feasible implementations, the differentiated color display is merely an example implementation. The first object and the second object may also be displayed in a differentiated manner by other methods, such as hatch fill, highlighting the object, or selecting the object with an outline. The embodiments of the present application do not limit the specific differentiated display manner of the first object and the second object. In the embodiments of the present application, the selected objects and the unselected objects may be displayed in a graphical manner, so as to help the user perceive the selection result.

In some feasible implementations, all objects included in the three-dimensional model may be displayed in a first zone. In this case, after the first object and the second object are displayed in a differentiated manner, the terminal device may also enlarge and display, in a second zone, all objects in a target zone in response to the user selecting the target zone in the first zone.

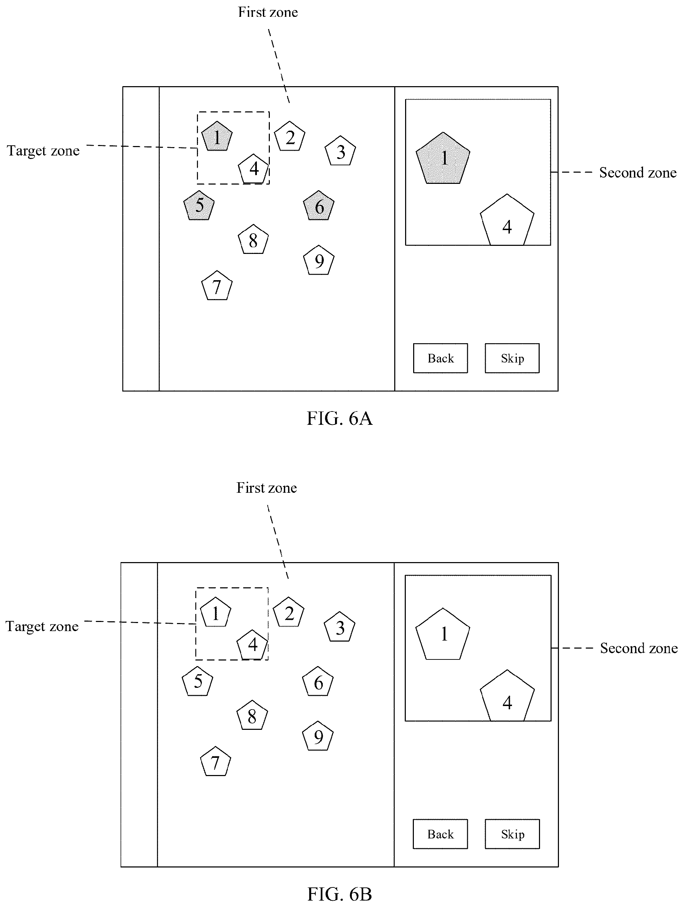

The first zone displays all the objects of the three-dimensional model, and the second zone displays all the objects in the target zone. As shown in FIG. 6A, all the objects of the three-dimensional model, for example, object 1, object 2, object 3, object 4, object 5, object 6, object 7, object 8, and object 9, are displayed in the first zone. The user selects the target zone in the first zone, where the target zone includes object 1 and object 4, and the terminal device may enlarge and display the object 1 and the object 4 in the second zone.

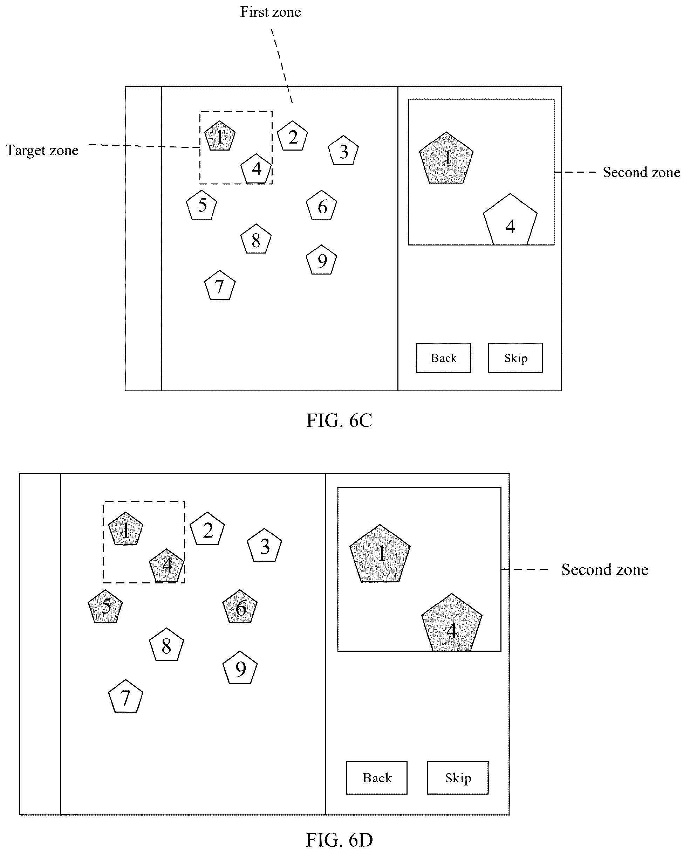

In one embodiment, in some feasible implementations, after all objects of the three-dimensional model are displayed in the first zone, the terminal device may enlarge and display, in the second zone, all objects in the target zone in response to the user selecting the target zone in the first zone, and may also display the first object and the second object in a differentiated manner in response to the user selecting the first object from all the objects in the target zone. The terminal device may display the first object and the second object in a differentiated manner in at least one of the first zone and the second zone. Illustratively, as shown in FIG. 6B, all the objects of the three-dimensional model, for example, object 1, object 2, object 3, object 4, object 5, object 6, object 7, object 8, and object 9, are displayed in the first zone. The user selects the target zone in the first zone, where the target zone includes object 1 and object 4, and the terminal device may enlarge the object 1 and the object 4 in the second zone. When the user selects object 1 in the target zone, the terminal device may display as shown in FIG. 6C. That is, the terminal device displays the selected objects and the unselected objects in a differentiated manner in the first zone and the second zone.

In FIG. 6C, the selected objects and the unselected objects are displayed in a differentiated manner in both the first zone and the second zone. In one embodiment, the first object and the second object may be displayed in a differentiated manner only in the first zone, or the first object and the second object may be displayed in a differentiated manner only in the second zone. The present application does not limit the zone in which the selected objects and the unselected objects are displayed in a differentiated manner.

Different from the embodiment described in FIG. 6A, in the embodiment of the present application, an object in the target zone is enlarged and then selected, while in the embodiment described in FIG. 6A, an object is selected before the target zone is enlarged. Implementation of the embodiments of the present application helps the user accurately select the object to be skipped from printing.

In one embodiment, for selection of the target zone, in one example, the terminal device may display a selection box in the first zone, and the user may perform a sliding operation on the selection box to select objects displayed in the first zone through the selection box. The zone boxed by the selection box in the first zone is the target zone, and all objects in the target zone are enlarged and displayed in the second zone. In another example, the user may perform a corresponding sliding operation in the first zone, the sliding track serves as the target zone, and all objects through which the sliding track passes are enlarged and displayed in the second zone. In yet another example, the user may perform a corresponding sliding operation in the first zone, a closed target zone is defined in the first zone through the sliding operation, and the terminal device may enlarge and display all objects in the target zone in the second zone. In yet another example, the user may perform a tap operation in the first zone, and the terminal device may circle the target zone in the first zone with a preset radius centered on a touch point of the tap operation. It can be understood that the above selection of the target zone is merely an example and should not be construed as limiting the manner of selecting the target zone in the embodiments of the present application.

In the implementation of the embodiments of the present application, the user may select objects of the three-dimensional model in the first zone by means of range selection, which enriches the interaction methods. Meanwhile, all the objects in the target zone are enlarged and displayed in the second zone based on the user's selection, thereby reducing visual interference, allowing the user to perceive the selected objects more intuitively and quickly, and facilitating further printing decisions by the user.

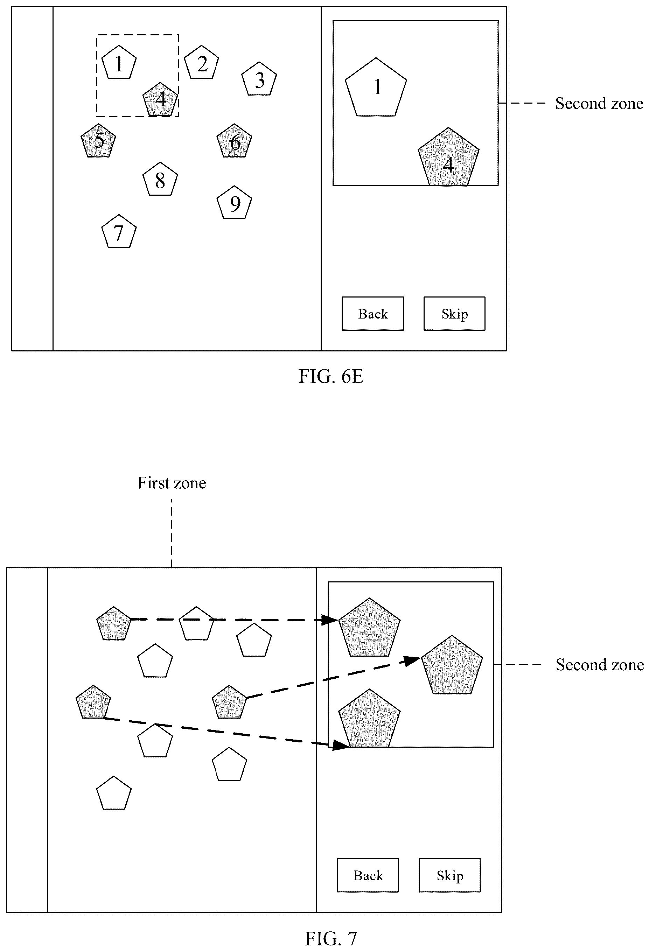

Further, in some feasible implementations, the terminal device may switch the selected first object in the target zone to an unselected state in response to an object selection operation of the user in the second zone. Illustratively, based on the embodiment described in FIG. 6A, the user selects object 1 in the second zone. In this case, the terminal device may display as shown in FIG. 6B, and the object 1 is switched to an unselected state. That is, the display of the object 1 is switched from gray fill to no fill. In one embodiment, the user selects object 4 in the second zone. In this case, the terminal device may display as shown in FIG. 6D, and the object 4 is switched to a selected state. That is, the display of the object 4 is switched from no fill to gray fill. In one embodiment, in some feasible implementations, the user selects object 1 and object 4 in the second zone. In this case, the terminal device may display as shown in FIG. 6E, the object 1 is switched to an unselected state, and the object 4 is switched to a selected state. That is, the display of the object 1 is switched from gray fill to no fill, and the display of the object 4 is switched from no fill to gray fill. In the embodiments of the present application, some objects are enlarged and displayed in the second zone, thereby effectively reducing visual interference, allowing the user to perform a targeted selection operation on a small number of objects, and improving the accuracy of object selection. Meanwhile, by performing a secondary selection of the objects in the enlarged second zone, the accuracy and flexibility of object selection are improved.

In some feasible implementations, all objects included in the three-dimensional model may be displayed in the first zone. In this case, after the first object and the second object are displayed in a differentiated manner, the terminal device may directly enlarge and display the first object in the first zone or the second object in the second zone. As a result, in the case that the first object and the second object are displayed in a differentiated manner in the first zone, the first object or the second object may be further enlarged and displayed in the second zone, thereby reducing visual interference, allowing the user to perceive the selected objects or the unselected objects more intuitively and quickly, and facilitating further printing decisions by the user.

Referring to FIG. 7, further, for the first object or the second object enlarged and displayed in the second zone, the terminal device may also switch the selected first object in the first zone to an unselected state or switch the unselected second object in the first zone to a selected state in response to an object selection operation of the user in the second zone. As a result, by enlarging and displaying some objects in the second zone, the visual interference is effectively reduced, the user is allowed to perform a targeted selection operation on a small number of objects, and the accuracy of object selection is improved. Meanwhile, by performing a secondary selection of the objects in the second zone, the tolerance and flexibility of object selection are improved, which is beneficial for improving the accuracy of 3D printing.

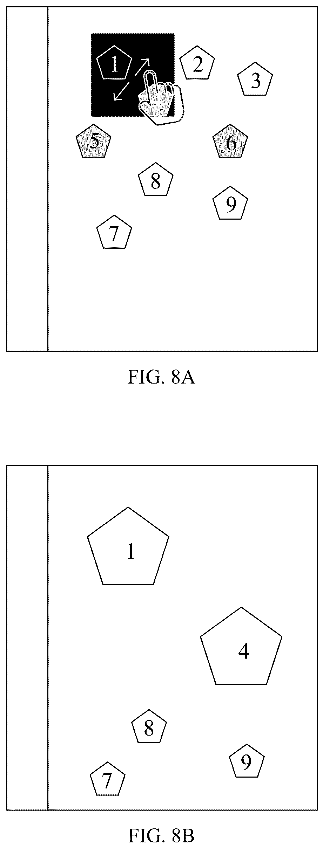

In one embodiment, in some feasible implementations, the terminal device may enlarge and display at least one of the first object or the second object in response to the user performing a zoom-in operation on a partial zone of the first zone. Illustratively, as shown in FIG. 8A, the user performs a zoom-in operation on a partial zone of the first zone. In this case, the terminal device may display as shown in FIG. 8B. In one embodiment, the terminal device may also reduce and display at least one of the first object or the second object in response to the user performing a zoom-out operation on a partial zone of the first zone, thereby providing different interaction methods for the user and enhancing the user's interaction experience during the 3D printing process. Further, the terminal device may switch, in response to an object selection operation of the user in the partial zone, the selected first object in the partial zone to an unselected state, and/or the unselected second object in the partial zone to a selected state.

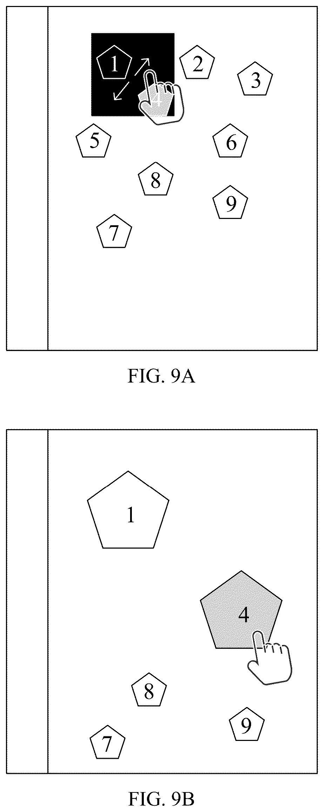

In some other feasible implementations, all objects included in the three-dimensional model may be displayed in the first zone. In this case, the terminal device may enlarge and display all objects in a partial zone of the first zone in response to the user performing a zoom-in operation on the partial zone of the first zone. Illustratively, as shown in FIG. 9A, the user performs a zoom-in operation on a partial zone of the first zone. Further, the terminal device may display the first object and the second object in a differentiated manner in response to the user selecting the first object from all the objects in the partial zone of the first zone. That is, the terminal device selects object 4 from object 1 and object 4. In this case, the terminal device may display as shown in FIG. 9B. Different from the embodiments described in FIGs. 8A and 8B in which the user selects the object before zooming in the object, in the embodiment of the present application, before the user selects the object, the object in the partial zone is first enlarged and then selected. Implementation of the embodiments of the present application helps the user accurately select the object to be skipped from printing.

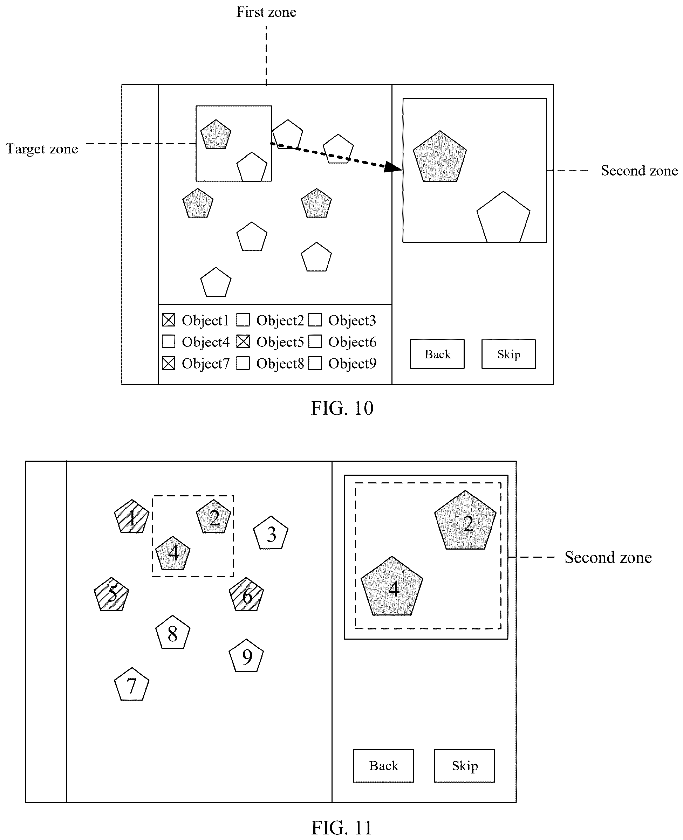

In one embodiment, in some feasible implementations, referring to FIG. 10, each object in the three-dimensional model may correspond to an object identifier. In this case, the terminal device may, while displaying all objects of the three-dimensional model through the first zone, display the object identifier corresponding to each object in the third zone, and each object identifier supports interactive operations. In other words, in addition to performing a corresponding object selection operation in the first zone, the user may also perform an identifier selection operation on an object identifier in the third zone. The terminal device may switch, in response to an object selection operation of the user in the third zone, the selected first object in the target zone to an unselected state, and/or the unselected second object in the target zone to a selected state, thereby allowing the user to select objects of the three-dimensional model in the third zone by means of identifier selection, which enriches the interaction methods.

It should be noted that the object identifiers displayed in the third zone may also be displayed in a differentiated manner based on the user's selection operation, and the corresponding differentiated display process may refer to the description in the aforementioned embodiments, which will not be repeated here.

Further, in some feasible implementations, the terminal device may also display the third object in a manner differentiated from the display manner of the first object and the second object in response to the user selecting the third object from all the objects included in the three-dimensional model. Illustratively, referring to FIG. 11, the first object selected by the user from the three-dimensional model includes object 1, object 5, and object 6, and is displayed with line fill, the second object includes object 3, object 7, object 8, and object 9, and is displayed without fill, and the third object includes object 2 and object 4, and is displayed with gray fill. In one embodiment, the first object may be understood as objects previously selected by the user, and the third object may be understood as objects currently selected by the user. That is, based on the embodiment described above with reference to FIG. 6A, the terminal device may display, in response to the user selecting the third object from all the objects included in the three-dimensional model, the previously selected object 1, object 5, and object 6 in another display manner, and the currently selected object 2 and object 4 with gray fill. That is, the previously selected objects and the currently selected objects are displayed in a differentiated manner.

In the implementation of the embodiments of the present application, the first object, the second object, and the third object may be displayed in a differentiated manner based on the user's selection result, such that the previously selected objects can be distinguished from the currently selected objects in an intuitive and easily identifiable way.

In step 303, the first object is controlled to be skipped from printing and the second object is controlled to be printed; or the first object is controlled to be printed and the second object is controlled to be skipped from printing.

Skipping printing refers to skipping the printing of at least one object in the three-dimensional model, at least one part in the same object, or at least one part in different objects during the printing process of the three-dimensional model. That is, skipping printing may be understood as not printing.

In some feasible implementations, before the 3D printer prints the three-dimensional model, a terminal device other than the 3D printer and the display module in the 3D printer, for example, at least one of a desktop computer, a laptop, a tablet computer, a smart screen, and a mobile phone terminal that establishes a communication connection with the 3D printer, may slice all objects in the three-dimensional model, or transmit all the objects in the three-dimensional model to a cloud server for slicing. In this case, the terminal device other than the 3D printer and the display module in the 3D printer or the cloud server may transmit, to the 3D printer, the gcode code generated by slicing and the ID of the gcode code segment corresponding to the first object or the second object. In one embodiment, the 3D printer or the display module in the 3D printer may also slice all the objects in the three-dimensional model to obtain the gcode code generated by slicing and the ID of the gcode code segment corresponding to the first object or the second object.

In a specific implementation, there is a correspondence between the display manner of an object and a gcode code segment corresponding to the object. For example, there is a correspondence between a gray-filled object and the ID of a first gcode code segment corresponding to the gray-filled object. If the first object is an object to be skipped from printing, the 3D printer does not execute the corresponding first gcode code segment and skips the printing of the first object during the printing process of the three-dimensional model. For another example, there is a correspondence between an unfilled object and the ID of a second gcode code segment corresponding to the unfilled object. If the second object is an object to be skipped from printing, the 3D printer does not execute the corresponding second gcode code segment and skips the printing of the second object during the printing process of the three-dimensional model. In one embodiment, there is a correspondence between the location of an object and a code segment of the gcode code that has the same location. For example, there is a correspondence between the location of the first object and the location of the corresponding first gcode code segment. If the first object is an object to be skipped from printing, the 3D printer does not execute the corresponding first gcode code segment and skips the printing of the first object during the printing process of the three-dimensional model. For another example, there is a correspondence between the location of the second object and the location of the corresponding second gcode code segment. If the second object is an object to be skipped from printing, the 3D printer does not execute the corresponding second gcode code segment and skips the printing of the second object during the printing process of the three-dimensional model.

In one embodiment, in some feasible implementations, the three-dimensional model includes the first object and the second object. If the first object is an object to be skipped from printing, before the 3D printer prints the three-dimensional model, a terminal device other than the 3D printer and the display module in the 3D printer may slice the second object, or transmit the second object in the three-dimensional model to a cloud server for slicing. In this case, the terminal device other than the 3D printer and the display module in the 3D printer or the cloud server may transmit, to the 3D printer, the gcode code generated by slicing. Since the gcode code does not include the slicing results of the first object, the 3D printer may skip the printing of the first object and print the second object by executing the gcode code during the printing process of the three-dimensional model. In one embodiment, the 3D printer or the display module in the 3D printer may also slice the second object in the three-dimensional model to obtain the gcode code generated by slicing. The 3D printer may skip the printing of the first object and print the second object by executing the gcode code during the printing process of the three-dimensional model. In the embodiments of the present application, the object to be skipped from printing may not be sliced at all, for example, slicing of the first object is directly skipped, which saves software resources and improves printing efficiency.

During the printing process of the three-dimensional model, based on the user's selection of the object in the three-dimensional model described above, printing may be performed or printing may be skipped based on the state of the object (selected state, unselected state, or the like). As a result, different print operations are performed based on the classification result, including printing some objects and skipping the printing of other objects. This not only enables personalized 3D printing but also improves the accuracy and flexibility of 3D printing, making it adaptable to printing scenarios with different needs.

In one embodiment, an object may include at least one part, and all parts included in the same object share the same printing parameters. When the user selects the corresponding object to be skipped from printing, all parts included in the object may be skipped from printing.

Further, any object included in the three-dimensional model may include a first part and a second part. In the case that the terminal device prints the first object, the terminal device may display the first part and the second part in the first object in a differentiated manner in response to the user selecting the first part from the first object, and control the first part to be skipped from printing and control the second part to be printed, or control the first part to be printed and control the second part to be skipped from printing during the printing process of the first object. As a result, during the 3D printing process, in addition to selecting corresponding objects, the user may also select parts from a finer granularity dimension, and the parts are displayed in a differentiated manner based on the user's selection. In one aspect, through the visual display effect, different types of parts are displayed in a differentiated manner intuitively and quickly, so as to help the user perceive the selection result. In another aspect, the user may classify all parts included in the three-dimensional model as required, so as to perform different print operations based on the classification result, including printing some parts and skipping the printing of other parts. This not only enables personalized 3D printing but also improves the accuracy and flexibility of 3D printing, making it adaptable to printing scenarios with different needs.

In the embodiments of the present application, all objects included in the three-dimensional model are displayed, so as to help the user know the objects included in the three-dimensional model that need to be printed, and improve the user's information perception of the three-dimensional model. In addition, the user may make personalized selections of all the objects included in the three-dimensional model, and the objects are classified and displayed in a differentiated manner based on the user's selection. In one aspect, through the visual display effect, different types of objects are displayed in a differentiated manner intuitively and quickly, so as to help the user perceive the selection result. In another aspect, the user may classify all objects included in the three-dimensional model as required, so as to perform different print operations based on the classification result, including printing some objects and skipping the printing of other objects. This not only enables personalized 3D printing but also improves the accuracy and flexibility of 3D printing, making it adaptable to printing scenarios with different needs.

The present application further provides a computer program product. The computer program product includes computer programs. The computer programs, when run by a processor, cause the processor to perform the embodiments described above with reference to FIGs. 1 to 6.

The embodiments of the present application further provide a non-transitory computer-readable storage medium storing computer instructions and having computer program instructions stored thereon. The computer instructions, when run by a processor, cause the processor to perform the embodiments described above with reference to FIGs. 1 to 6.

The non-transitory computer-readable storage medium storing the computer instructions includes read-only memory (ROM), random access memory (RAM), magnetic disks, optical disks, or the like.

It should be noted that the above terms "first" and "second" are only for the purpose of description, and may not be construed as indicating or implying the relative importance.

Those of ordinary skill in the art may understand that all or part of the steps of the above method embodiments may be performed by hardware related to program instructions. The aforementioned programs may be stored in a computer-readable storage medium. The programs, when run, perform the steps including the above method embodiments. The aforementioned storage medium includes various media capable of storing program code, such as mobile storage devices, read-only memory (ROM), random-access memory (RAM), magnetic disks, or optical disks.

Alternatively, if the above integrated units in the present application are implemented in the form of software functional modules and sold or used as independent products, they may also be stored in a computer-readable storage medium. Based on such understanding, the technical solutions of the embodiments of the present application in essence, or the parts contributing to the existing technology may be embodied in the form of a software product. This computer software product is stored in a storage medium and includes several instructions to enable a computer device (which may be a personal computer, a server, a network device, or the like) to perform all or part of the methods described in various embodiments of the present application. The aforementioned storage medium includes various media capable of storing program code, such as mobile storage devices, ROM, RAM, magnetic disks, or optical disks. The above descriptions are specific embodiments of the present application. However, the protection scope of the present application is not limited to this. Any variations or substitutions that those skilled in the art can easily think of within the technical scope disclosed in the present application should be included within the protection scope of the present application. Therefore, the protection scope of the present application should be subject to the protection scope defined by the claims.

## Claims

1. A 3D printing method, comprising:
displaying all objects comprised in a three-dimensional model, wherein all the objects comprised in the three-dimensional model comprise a first object and a second object;
displaying the first object and the second object in a differentiated manner in response to a user selecting the first object from all the objects comprised in the three-dimensional model during a printing process of the three-dimensional model;
controlling the first object to be skipped from printing and controlling the second object to be printed; or controlling the first object to be printed and controlling the second object to be skipped from printing.

2. The method according to claim 1, wherein displaying all the objects comprised in the three-dimensional model comprises:
displaying all the objects comprised in the three-dimensional model when detecting a user input on an object-skipping control.

3. The method according to claim 1 or 2, wherein all the objects comprised in the three-dimensional model are displayed in a first zone;
after the first object and the second object are displayed in the differentiated manner, the method further comprises:
enlarging and displaying all objects in a target zone in a second zone in response to the user selecting the target zone in the first zone.

4. The method according to claim 3, wherein the method further comprises:
switching, in response to an object selection operation of the user in the second zone, a selected first object in the target zone to an unselected state, and/or an unselected second object in the target zone to a selected state.

5. The method according to claim 1 or 2, wherein all the objects comprised in the three-dimensional model are displayed in a first zone;
displaying the first object and the second object in the differentiated manner in response to the user selecting the first object from all the objects comprised in the three-dimensional model comprises:
enlarging and displaying all objects in a target zone in a second zone in response to the user selecting the target zone in the first zone; and
displaying the first object and the second object in the differentiated manner in response to the user selecting the first object from all the objects comprised in the target zone.

6. The method according to claim 1 or 2, wherein all the objects comprised in the three-dimensional model are displayed in a first zone;
after the first object and the second object are displayed in the differentiated manner, the method further comprises:
enlarging and displaying at least one of the first object and the second object in response to the user performing a zoom-in operation on a partial zone of the first zone.

7. The method according to claim 6, wherein the method further comprises:
switching, in response to an object selection operation of the user in the partial zone, a selected first object in the partial zone to an unselected state, and/or an unselected second object in the partial zone to a selected state.

8. The method according to claim 1 or 2, wherein all the objects comprised in the three-dimensional model are displayed in a first zone;
displaying the first object and the second object in the differentiated manner in response to the user selecting the first object from all the objects comprised in the three-dimensional model comprises:
enlarging and displaying all objects in a partial zone of the first zone in response to the user performing a zoom-in operation on the partial zone of the first zone; and
displaying the first object and the second object in the differentiated manner in response to the user selecting the first object from all the objects comprised in the partial zone of the first zone.

9. The method according to any one of claims 1 to 8, wherein all the objects comprised in the three-dimensional model further comprise a third object;
the method further comprises:
displaying the third object in a manner differentiated from a display manner of the first object and the second object in response to the user selecting the third object from all the objects comprised in the three-dimensional model.

10. The method according to any one of claims 1 to 8, wherein all the objects comprised in the three-dimensional model further comprise a third object;
the method further comprises:
displaying the third object in a manner differentiated from a display manner of the first object and the second object.

11. The method according to any one of claims 1 to 8, wherein any object comprised in the three-dimensional model comprises a first part and a second part; controlling the first object to be printed comprises:
displaying the first part and the second part in the first object in a differentiated manner in response to the user selecting the first part from the first object;
controlling the first part to be skipped from printing and controlling the second part to be printed; or controlling the first part to be printed and controlling the second part to be skipped from printing.

12. The method according to any one of claims 1 to 11, wherein displaying the first object and the second object in the differentiated manner comprises:
displaying the first object in the three-dimensional model in a first color; and
displaying the second object in the three-dimensional model in a second color.

13. The method according to any one of claims 1 to 12, wherein an object comprises at least one part.

14. A terminal device, wherein the terminal device comprises a processor and a display, the display is configured to display objects comprised in a three-dimensional model, and the processor is configured to perform the method according to any one of claims 1 to 13.

15. A non-transitory computer-readable storage medium storing computer instructions and having computer program instructions stored thereon, wherein the computer program instructions, when run by a processor, cause the processor to perform the 3D printing method according to any one of claims 1 to 13.

16. A computer program product, wherein the computer program product comprises computer programs, and the computer programs, when run by a processor, cause the processor to perform the 3D printing method according to any one of claims 1 to 13.
